**Europäisches Patentamt**

**European Patent Office**

**Office européen des brevets**

(19)

(11) Veröffentlichungsnummer: **0 003 510**
**B1**

(12) **EUROPÄISCHE PATENTSCHRIFT**

(45) Veröffentlichungstag der Patentschrift:
07.01.81

(51) Int. Cl.³: **G 05 B 19/02, H 03 K 4/50 //**
**B29C17/07**

(21) Anmeldenummer: **79100124.1**

(22) Anmeldetag: **16.01.79**

(54) Rampengenerator zum Erzeugen eines Zeitsteuersignals für den Betrieb einer elektrischen Steuereinrichtung eines Extruders.

(30) Priorität: **31.01.78 DE 2804145**

(43) Veröffentlichungstag der Anmeldung:
**22.08.79 Patentblatt 79/17**

(45) Bekanntmachung des Hinweises auf die Patenterteilung:
**07.01.81 Patentblatt 81/1**

(84) Benannte Vertragsstaaten:
**BE CH DE FR GB IT NL SE**

(56) Entgegenhaltungen:
**DD-A-114 733**
**DE-A-2 445 394**
**DE-B-1 272 357**
**KUNSTSTOFFE, Band 61, 1971, Heft 9, Seite 648,**
**Mannheim,**
**Hunkar «Schlauchwanddicken-Programmierer für Hohl-**
**körper-Blasanlagen»**

(73) Patentinhaber: **MOOG GmbH, Hanns-Klemm-Strasse 28,**
**D-7030 Böblingen (DE)**

(72) Erfinder: **Handte, Herbert, Scherlachstrasse 51,**
**D-7024 Filderstadt 4 (DE)**
Erfinder: **Kollmar, Friedrich, Krähenweg 15,**
**D-7031 Grafenau 1 (DE)**

(74) Vertreter: **Patentanwälte Dipl.-Ing. A. Grünecker, Dr.-Ing.**
**H. Kinkeldey, Dr.-Ing. W. Stockmair,, Dr. rer. nat. K.**
**Schumann, Dipl.-Ing. P. Jakob, Dr. rer. nat. G. Bezold**
**Maximilianstrasse 43, D-8000 München 22 (DE)**

# Rampengenerator zum Erzeugen eines Zeitsteuersignals für den Betrieb einer elektrischen Steuereinrichtung eines Extruders

Die Erfindung bezieht sich auf einen Rampengenerator zum Erzeugen eines Zeitsteuersignals für den Betrieb einer elektrischen Steuereinrichtung eines Extruders, mit einem Integrator, der an seinem Ausgang zyklische, mit der Zeit konstant anwachsende Rampensignale abgibt, die durch Startsignale des Extruders getriggert werden, und eine Korrektureinrichtung, mit der die Anstiegszeit des Integrators einstellbar ist.

Bei der Herstellung von Blasformkörpern wird in einem Extruder zuerst ein zylindrischer Vorformling gebildet, der in einem sich daran anschliessenden Arbeitsgang in einer Blasform auf die gewünschte Form gebracht wird. Bei der Bildung des Vorformlings ist es erforderlich, der späteren Blasform insoweit schon Rechnung zu tragen, dass die Wandstärke über dem hohlzylindrischen Vorformling unterschiedlich stark ausgebildet wird. Dies wird bei Extrudern dadurch erreicht, dass der in einem Werkzeugkopf angeordnete Dorn, der gegenüber dem Werkzeugkopf einen ringförmigen Spalt begrenzt, längsverschiebbar ausgebildet ist, so dass die Spaltbreite variabel ist. Um nun das gewünschte Wandstärkenprofil des Vorformlings zu erhalten, muss der Dorn nach einer bestimmten Bewegungsfunktion im Werkzeugkopf hin- und herbewegt werden. Um diese Bewegungsfunktion zu erzeugen, wird eine Steuerschaltung verwendet, deren Arbeitsablauf nach Massgabe eines Führungssignals erfolgt. Umfasst der Extruder eine Kolbenanordnung, die bei jeder Hubbewegung die erforderliche Materialmenge ausstösst, so kann dieses Führungssignal durch einen Positionsmessumformer erzeugt werden. Das Ausgangssignal des Positionsmessumformers entspricht somit stets der jeweiligen Stellung des Kolbens. Bei kontinuierlich extrudierenden Maschinen kann das Führungssignal jedoch auf diese Weise nicht erzeugt werden, da kein Kolben verwendet wird, sondern eine sich kontinuierlich drehende Extruderschnecke. Es muss deshalb ein spezieller Rampengenerator für die Erzeugung des Führungssignals vorgesehen werden, der durch einen von der Maschine erzeugten Startimpuls in Gang gesetzt wird.

In der DT-OS 24 45 394 (Fig. 11) ist ein Rampengenerator der eingangs genannten Art bekannt. Dieser bekannte Rampengenerator enthält einen Verstärker, dessen einer Eingang mit dem Ausgang über einen Kondensator verbunden ist. Dem anderen Verstärkereingang wird ein konstantes Signal zugeführt. Die Grösse dieses Signals ist mittels eines Potentiometers einstellbar, um die Anstiegszeit des Ausgangssignals des Integrators von Hand variieren zu können. Bei jedem von dem Extruder abgegebenen Signal wird die Schaltung zurückgesetzt, damit ein neues Rampensignal beginnt. Die Anstiegszeit des Rampensignals wird manuell so eingestellt, dass die Rampenspannung dann ihre vorgegebene Maximalamplitude erreicht, wenn ein neuer Startimpuls von der Maschine eintrifft. Beim Anfahren der Maschine wird hierzu als erstes die Zykluszeit der Maschine gemessen, anschliessend wird die Anstiegszeit grob eingestellt. Danach wird bei laufender Maschine die Einstellung manuell optimiert. Es ist eine beträchtliche Anzahl von Zyklen erforderlich, um die gewünschte Einstellung zu erreichen. In dieser Zeit wird nur Ausschuss produziert. Wird die Zykluszeit der Maschine geändert, so ist eine neuerliche Einstellung der Rampenanstiegszeit erforderlich. Sind Zykluszeit oder Anstiegszeit der Rampenfunktion einer Langzeit- oder Temperaturdrift unterworfen, so werden fehlerhafte Artikel erzeugt. Es ist also notwendig, eine laufende Kontrolle und gegebenenfalls eine Nacheinstellung durchzuführen.

Der Erfindung liegt die Aufgabe zugrunde, einen Rampengenerator der obengenannten Art so weiterzubilden, dass eine manuelle Einstellung überflüssig wird.

Ausgehend von einem Rampengenerator der eingangs genannten Art wird diese Aufgabe erfindungsgemäss durch die im kennzeichnenden Teil des Anspruchs 1 angegebenen Merkmale gelöst.

Im Gegensatz zur manuellen Betätigung, vor der das Produkt daraufhin geprüft wurde, ob es den Anforderungen entsprach, werden bei der erfindungsgemässen Korrektureinrichtung die aufeinanderfolgenden Startimpulse der Maschine, d.h. deren zeitlicher Abstand, dazu verwendet, das zur Korrektur erforderliche Steuersignal abzuleiten. Die erfindungsgemässe Anordnung arbeitet automatisch, und zwar wird bei jedem einzelnen Zyklus eine zeitliche Verschiebung des Nachfolgeimpulses berücksichtigt. Das bedeutet, dass z.B. beim Anfahren der Maschine oder beim Ändern der Zykluszeit nur ein Stück Ausschuss entsteht. Da Langzeit- und Temperaturdrifterscheinungen fortlaufend berücksichtigt werden, ist eine laufende Kontrolle der Einrichtung nicht mehr notwendig.

Eine bevorzugte Ausführungsform der Erfindung ist in Anspruch 2 angegeben. Das Bezugssignal, mit dem das Rampenausgangssignal verglichen wird, kann vorzugsweise auf die Maximalamplitude des Rampensignals eingestellt werden. Bei jedem Startimpuls wird das Korrektursignal in die Speicherschaltung eingegeben, wo es für den nachfolgenden Zyklus zur Verfügung steht. Ändert sich ein Nachfolge-Startsignal, d.h., kommt es früher oder später als erwartet an, so wird das Korrektursignal entsprechend erhöht oder vermindert, um die Anstiegszeit des Rampensignals zu erhöhen bzw. zu vermindert, damit die vorgegebene Maximalamplitude des Rampensignals schneller bzw. langsamer erreicht wird.

Eine besonders günstige Ausführungsform der Erfindung ist in Anspruch 3 angegeben. Das am Multipliziererausgang erhaltene Signal steigt linear nach Massgabe des Rampenausgangssignals, das einem Multipliziereingang zugeführt wird, an; der andere Eingang des Multiplizierers empfängt das für jeweils einen Zyklus konstante Korrektursignal, das von dem Speicher abgegeben wird. Es herrscht also ein proportionaler Zusammenhang zwischen dem Betrag des Korrektursignals und der Anstiegszeit des Rampensignals.

Im folgenden wird ein Anschauungsbeispiel der Erfindung anhand der Zeichnung näher erläutert. Es zeigen:

Fig. 1 eine schematische Skizze, die das Grundprinzip des erfindungsgemässen Rampengenerators veranschaulicht,

Fig. 2 ein vereinfachtes Blockschaltbild eines erfindungsgemässen Rampengenerators, und

Fig. 3 eine Schaltungsanordnung des Rampengenerators nach Fig. 2.

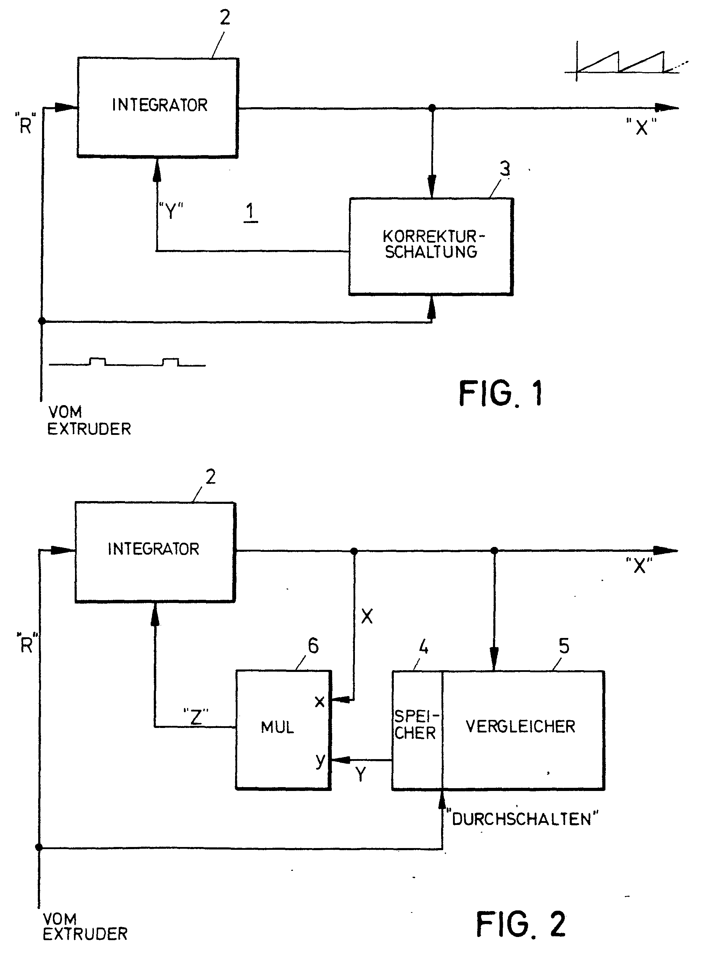

Fig. 1 zeigt die prinzipielle Anordnung eines erfindungsgemässen Rampengenerators 1. Ein Integrator 2 liefert an seinem «X» bezeichneten Ausgang Rampen- oder Sägezahnsignale. Der Beginn jedes einzelnen Rampensignals wird bestimmt durch ein vom Extruder erzeugtes Startsignal, das dem Integrator in Form eines Rücksetzsignals «R» zugeführt wird. Gleichzeitig wird die vom Extruder ankommende Folge der Startsignale einer Korrekturschaltung 3 zugeleitet, in der der zeitliche Abstand zwischen zwei aufeinanderfolgenden Startsignalen umgewandelt wird in ein Spannungssignal, dessen Amplitude von dem zeitlichen Abstand der aufeinanderfolgenden Signale abhängig ist. Dieses Korrektursignal «Y» wird dem Integrator 2 zugeführt, um die Anstiegszeit des jeweiligen erzeugten Rampensignals zu vergrössern, bzw. zu vermindern.

Fig. 2 zeigt ein Blockschaltbild einer speziellen Ausführungsform des erfindungsgemässen Rampengenerators. Die Korrekturschaltung besteht aus einem Vergleicher 5, dem eine Speicherschaltung 4 nachgeschaltet ist. Dem Vergleicher wird das Rampensignal «X» zugeführt. In dem Vergleicher 5 wird festgestellt, ob beim Eintreffen eines Impulses «Durchschalten», der von dem Startsignal abgeleitet wird, die Rampenspannung eine vorgegebene Amplitude unter- oder überschreitet, oder ob das Rampensignal exakt dem vorgegebenen Wert entspricht. Abhängig vom Vergleichsergebnis wird der Speicherschaltung 4 ein entsprechendes Korrektursignal zugeleitet, wo es für den nachfolgenden Zyklus zur Verfügung steht. Der Ausgang der Speicherschaltung wird dem Eingang «y» eines Multiplizierers 6 zugeführt. Der andere Eingang des Multiplizierers 6 «x» wird mit dem Rampenausgangssignal «X» beaufschlagt. Der Multiplizierer bildet folgende Ausgangsspannung «Z»:

$$Z = \frac{X \cdot Y}{10\,\text{Volt}} \;[\text{Volt}] \qquad (1)$$

Im folgenden werden die Spannungen «Z», «X» und «Y» auf 10 Volt normiert, um die Schreibweise zu erleichtern. Demnach ergibt sich aus Gleichung (1):

$$Z = X \cdot Y \qquad (2)$$

An dem Ausgang des Multiplizierers entsteht nach jedem Rücksetzvorgang durch das Signal «R» eine Spannung, die linear mit der Zeit anwächst. Da die Korrekturspannung «Y» für den gesamten Zyklus konstant ist, ergibt sich für das Signal «X» ebenfalls ein zeitlich linearer Anstieg gemäss

$$X = \frac{Z}{Y} \qquad (3)$$

Betrachtet man die Gleichung

$$\hat{X} = \frac{K \cdot t_A}{Y} \qquad (4)$$

wobei $\hat{X}$ der vorgegebene maximale Spitzenwert für die Rampenspannung, K eine Konstante und t die Zeit darstellen, so sieht man, dass mit anwachsendem Wert von «Y» eine immer längere Zeit benötigt wird, um den Spitzenwert $\hat{X}$ zu erreichen.

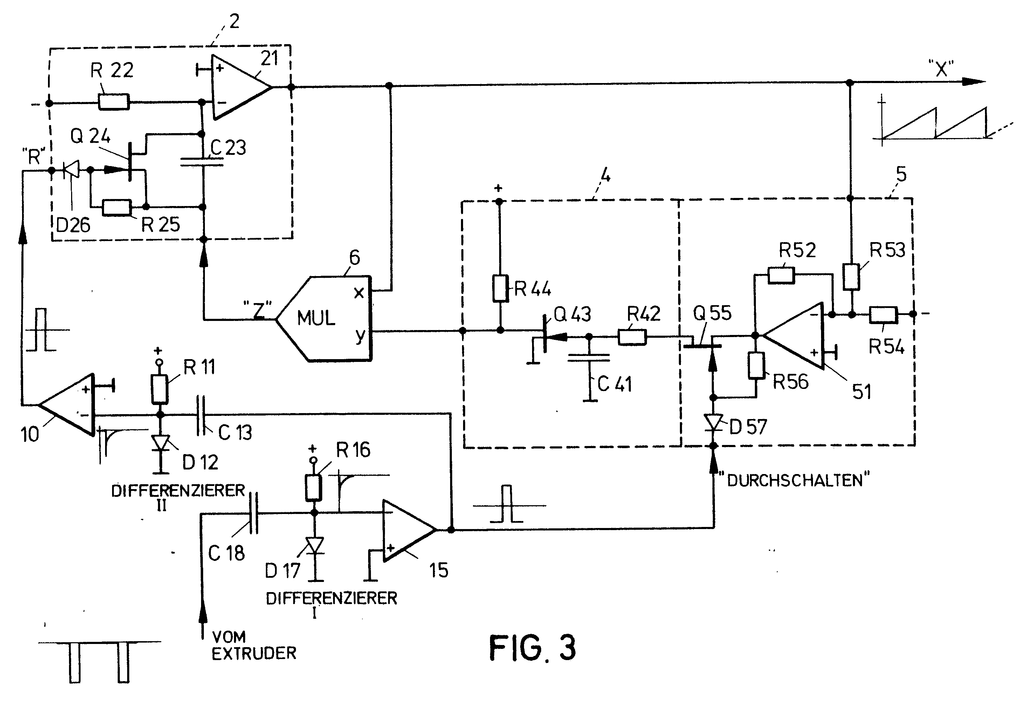

Fig. 3 zeigt eine Schaltungsanordnung des in Fig. 2 gezeigten Rampengenerators. Der Integrator 2 besteht aus einem Operationsverstärker 21, dessen «+»-Eingang auf Masse liegt. Der invertierende Eingang ist über einen Widerstand R22 mit Minus-Potential verbunden. Ferner ist an den invertierenden Eingang ein Kondensator C23 geschaltet, der von einem Feldeffekttransistor Q24 überbrückt wird, dessen Source- und Gate-Elektroden über einen Widerstand R25 verbunden sind. Dem Gate des Feldeffekttransistors Q24 ist eine Diode D26 vorgeschaltet.

Die Speicherschaltung 4 umfasst ein aus einem Kondensator C41 und einem Widerstand R42 bestehendes RC-Glied. Der Verbindungspunkt des Kondensators C41 und des Widerstandes R42 ist mit der Gate-Elektrode eines selbstleitenden Feldeffekttransistors Q23 verbunden. Die Source-Elektrode des Feldeffekttransistors Q43 liegt auf der Masse, die Drain-Elektrode dieses Feldeffekttransistors ist über einen Widerstand R44 mit Plus-Potential verbunden. Die Vergleicheranordnung 5 umfasst einen Operationsverstärker 51, dessen «+»-Eingang auf Erde liegt, und dessen invertierender Eingang über einen Widerstand R52 mit seinem Ausgang verbunden ist. Weiterhin ist der invertierende Eingang des Operationsverstärkers 51 mit dem Mittelanzapfpunkt eines Spannungsteilers R53, R54 verbunden. Die freie Klemme des Widerstandes R54 liegt auf Minus-Potential, während die freie Klemme des Widerstandes R53 mit dem Ausgang des Rampengenerators verbunden ist. Der Spannungsteiler ist so dimensioniert, dass am invertierenden Eingang des Verstärkers 51 dann ein Potential von 0 Volt liegt, wenn die Rampenausgangsspannung den vorgegebenen Wert von +10 Volt hat. Zwischen dem Ausgang des Verstärkers 51 und der Eingangsklemme der Speicherschaltung 4, d.h., der freien Klemme des Widerstandes R42, befindet sich ein einen Feldeffekttransistor Q55 aufweisender Schalter. Source- und Gate-Elektrode des Feldeffekttransistors Q55 sind über einen Widerstand R56 miteinander verbunden. Ferner ist dem Gate des Feldeffekttransistors Q55 eine Diode D57 vorgeschaltet.

Der Ausgang des Speichers 4 ist mit dem Eingang y des Multiplizierers 6 verbunden. Der andere Eingang x des Multiplizierers 6 ist mit dem Ausgang des Integrators 2 verbunden. Der Ausgang des Multiplizierers 6 ist mit einer Elektrode des Kondensators C23 des Integrators 2 verbunden. Das vom Extruder kommende Startsignal wird über einen Differenzierer I dem Eingang «Durchschalten» der Vergleicheranordnung 5 zugeführt. Das Ausgangssignal des Differenzierers I wird über einen Differenzierer II dem Rücksetzeingang «R» des Integrators 2 zugeleitet.

Im folgenden wird die Funktionsweise des Rampengenerators gemäss Fig. 3 erläutert. Beim Einschalten des Rampengenerators kann davon ausgegangen werden, dass sämtliche Kondensatoren der Schaltung entladen sind. Dementsprechen leitet der Feldeffekttransistor Q43, so dass am Eingang y des Multiplizierers 6 eine kleine positive Spannung anliegt. Da der Operationsverstärker 21 über dem Multiplizierer 6 und den Kondensator C23 gegengekoppelt ist, wird sich am invertierenden Eingang des Operationsverstärkers 21 immer 0 Volt einstellen. Da der Kondensator C23 entladen ist, ist «Z» 0 Volt und somit auch das Rampenausgangssignal «X». Bei gesperrtem Feldeffekttransistor Q24 fliesst über den Widerstand R22 ein konstanter Strom J, der den Kondensator C23 gemäss folgender Beziehung auflädt:

$$U_{C23} = \frac{J \cdot t}{C_{23}} = Z \qquad (5)$$

Entsprechend Gleichung (4) kann man nun für den Spitzwert der Rampenspannung $\hat{X}$ anschreiben.

$$X = \frac{J \cdot t_A}{C_{23} \cdot Y} \qquad (6)$$

Hieraus ergibt sich die Zeit, die notwendig ist, um den vorgegebenen Wert X zu erreichen:

$$t_A = \frac{X \cdot C_{23}}{J} \cdot Y \qquad (7)$$

Die Anstiegszeit $t_A$ ist somit proportional zu der Korrekturspannung «Y». Ein vom Extruder abgegebener Startimpuls wird durch den aus einem Kondensator C18, einem Widerstand R16 und einer Diode D17 bestehenden Differenzierer in einen negativen Nadelimpuls umgewandelt. Der Operationsverstärker 15 macht hieraus einen kurzen positiven Impuls, der z. B. 10 ms andauert. Dieser Impuls verbindet den Ausgang des Operationsverstärkers 51 mit dem Speicher 4, d.h., in dem Kondensator 41 wird eine entsprechende Spannung gespeichert. Laufen die Startimpulse von dem Extruder exakt synchron mit den einzelnen Rampensignalen «X», so steht im Speicher 4 stets dieselbe Korrekturspannung zur Verfügung. Ist die entsprechende Spannung «Y» in dem Speicher 4 bereitgestellt, so wird der Integrator 2 zurückgesetzt. Hierzu wird das Signal am Differenzierer I abgegriffen, in einem aus einem Widerstand R11, einer Diode D12 und einem Kondensator C13 bestehenden Differenzierer II in einen negativen Nadelimpuls umgewandelt, aus dem der Operationsverstärker 10 einen Impuls erzeugt, wie der Operationsverstärker 15, jedoch um die Dauer des Impulses am Operationsverstärker 15 zeitlich verzögert. Dieser Impuls schaltet den Feldeffekttransistor Q24 ein, wodurch der Kondensator C23 entladen wird. Nach dem Abfall des Impulses, d.h., nach dem Entladen des Kondensators, wird der Feldeffekttransistor Q24 wieder gesperrt, so dass ein neues Rampensignal erzeugt werden kann.

Wenn sich nun die Zeit zwischen zwei aufeinanderfolgenden Startsignalen ändert, muss die Korrekturspannung «Y» entsprechend geändert werden. Als Beispiel soll zuerst einmal angenommen werden, ein Nachfolge-Startsignal komme später an als vorgesehen. In der zusätzlich verstrichenen Zeit ist das Rampensignal «X» Generatorausgang über den Vorgabewert von 10 Volt angestiegen. Das hat zur Folge, dass am invertierenden Eingang des Operationsverstärkers 51 eine Spannung anliegt, die die gewünschte Spannung von 0 Volt übersteigt. Wird nun der Feldeffekttransistor Q25 leitend, so wird in dem Kondensator C14 eine Spannung gespeichert, die zur Folge hat, dass der Feldeffekttransistor C43 weniger leitet. Hierdurch wird das Potential an der Eingangsklemme y des Multiplizierers 6 angehoben, was zur Folge hat, dass sich die Anstiegszeit des nachfolgend erzeugten Rampensignals entsprechend dem Abstand der beiden letzten Startimpulse erhöht. Weisen die nachfolgenden Startimpulse einen entsprechenden zeitlichen Abstand auf, so wird der Feldeffekttransistor C55 genau dann geöffnet, wenn am Eingang die gewünschte Spannung von 0 Volt anliegt, d.h., wenn das Rampensignal den gewünschten Spitzenwert von +10 Volt erreicht hat. Im umgekehrten Fall, d.h., wenn sich der Abstand zwischen zwei aufeinanderfolgenden Startimpulsen verringert, wird der Feldeffekttransistor Q55 früher angeschaltet, so dass der Feldeffekttransistor Q43 besser leitet, um hierdurch die Korrekturspannung «Y2» herabzusetzen, was zur Folge hat, dass auch die Anstiegszeit der Rampensignals verkürzt wird.

Wie aus der obigen Beschreibung hervorgeht, wird also lediglich ein einziger Zyklus zum korrekten Einstellen der erforderlichen Anstiegszeit des Rampengenerators benötigt. Da die Einstellung bei jedem Zyklus von neuem erfolgt, werden Drif-

terscheinungen (z. B. Langzeitdrift oder Temperaturdrift) sofort korrigiert.

## Patentansprüche

1. Rampengenerator zum Erzeugen eines Zeitsteuersignals für den Betrieb einer elektrischen Steuereinrichtung eines Extruders, mit einem Integrator, der an seinem Ausgang zyklische, mit der Zeit konstant anwachsende Rampensignale abgibt, die durch Startsignale des Extruders getriggert werden, und einer Korrektureinrichtung, mit der die Anstiegszeit des Integrators einstellbar ist, dadurch gekennzeichnet, dass die Korrektureinrichtung (4, 5) mit den Startsignalen beaufschlagt wird und ein Steuersignal abgibt, das von dem zeitlichen Abstand zweier aufeinanderfolgender Startimpulse abhängt.

2. Rampengenerator nach Anspruch 1, dadurch gekennzeichnet, dass die Korrektureinrichtung einen Vergleicher (5) umfasst, dem das Ausgangssignal des Rampengenerators zugeführt wird und in dem es mit einem Bezugssignal verglichen wird, und dass der Ausgang des Vergleichers (5) in Abhängigkeit von dem Startsignal mit dem Eingang einer Speicherschaltung (4) verbunden wird, an deren Ausgang (Q43) das Steuersignal abgegriffen wird.

3. Rampengenerator nach Anspruch 2, dadurch gekennzeichnet, dass der Ausgang der Speicherschaltung (4) mit dem ersten Eingang eines Multiplizierers (6) verbunden ist, dessen anderem Eingang das Rampenausgangssignal des Integrators (2) zugeführt wird und dessen Ausgang mit dem Eingang des Integrators (2) verbunden ist.

## Patent Claims

1. A ramp generator for producing a timing signal for operating an electric control means of an extruder, comprising an integrator supplying at its output cyclic ramp signals which increase constantly as a function of time and which are triggered by start signals of the extruder and further comprising a correction means with the aid of which the rise time of the integrator can be adjusted, characterized in that the correction means (4, 5) is acted upon by the start signals and provides a control signal which depends on the time interval between two successive start pulses.

2. A ramp generator according to claim 1, characterized in that the corrections means includes a comparator (5) to which the output signal of the ramp generator is supplied, said output signal being compared with a reference signal in said comparator, and that the output of the comparator (5) is connected to the input of a storage circuit (4) in response to the start signal, the control signal being tapped off the output (Q43) of said storage circuit (4).

3. A ramp generator according to claim 2, characterized in that the output of the storage circuit (4) is connected to the first input of a multiplier (6) whose other input has supplied thereto the output ramp signal of the integrator (2) and whose output is connected to the input of the integrator (2).

## Revendications

1. Générateur de dents de scie destiné à produire un signal de synchronisation pour le contrôle du fonctionnement d'un dispositif de commande électrique d'extrudeuse, ledit générateur comportant un intégrateur, qui engendre à sa sortie des signaux en dents de scie cycliques croissant de façon constante avec le temps et qui sont déclenchés par des signaux de démarrage produits par l'extrudeuse et un dispositif de correction au moyen duquel le temps de montée de l'intégrateur est réglable, ledit générateur de dents de scie étant caractérisé en ce que le dispositif de correction (4, 5) reçoit les signaux de démarrage et émet un signal de commande qui est fonction de l'intervalle temporel entre deux impulsions de démarrage successives.

2. Générateur de dents de scie suivant la revendication 1, caractérisé en ce que le dispositif de correction comprend un comparateur (5), auquel le signal de sortie du générateur de dents de scie est transmis, et dans lequel ce signal est comparé avec un signal de référence, et en ce que la sortie du comparateur (5) est reliée, sous le contrôle du signal de démarrage, à l'entrée d'une mémoire (4) à la sortie (Q43) de laquelle le signal de commande est recueilli.

3. Générateur de dents de scie suivant la revendication 2, caractérisé en ce que la sortie de la mémoire (4) est connectée à la première entrée d'un multiplieur (6), à l'autre entrée duquel est transmis le signal de sortie en dents de scie de l'intégrateur (2) et dont la sortie est reliée à l'entrée dudit intégrateur (2).

FIG. 1

FIG. 2

**FIG. 3**

"X"

R53 R54

R52 51 R56

D57 "DURCHSCHALTEN"

Q55

R42 C41

4

Q43 R44

5

6 MUL x y

"Z"

2 21 C23

R22 Q24 R25 D26

"R"

10

R11 C13 D12

DIFFERENZIERER II

15

R16 D17 DIFFERENZIERER I

C18

DIFFERENZIERER

VOM EXTRUDER